(19) Europäisches Patentamt
European Patent Office
Office européen des brevets

(11) **EP 3 350 607 B1**

(12) **EUROPÄISCHE PATENTSCHRIFT**

(45) Veröffentlichungstag und Bekanntmachung des Hinweises auf die Patenterteilung:
**27.04.2022 Patentblatt 2022/17**

(21) Anmeldenummer: **16766893.8**

(22) Anmeldetag: **09.09.2016**

(51) Internationale Patentklassifikation (IPC):
**G01R 31/72** (2020.01)    **G01R 31/34** (2020.01)

(52) Gemeinsame Patentklassifikation (CPC):
**G01R 31/34; G01R 31/72;** G01R 31/62

(86) Internationale Anmeldenummer:
**PCT/EP2016/071308**

(87) Internationale Veröffentlichungsnummer:
**WO 2017/046011 (23.03.2017 Gazette 2017/12)**

(54) **MESSVERFAHREN ZUR BESTIMMUNG VON EISENVERLUSTEN**

MEASUREMENT METHOD FOR DETERMINING IRON LOSSES

PROCÉDÉ DE MESURE DESTINÉ À LA DÉTERMINATION DE PERTES DE FER

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.09.2015 DE 102015115447**

(43) Veröffentlichungstag der Anmeldung:
**25.07.2018 Patentblatt 2018/30**

(73) Patentinhaber: **Friedrich-Alexander-Universität Erlangen-Nürnberg**
**91054 Erlangen (DE)**

(72) Erfinder:
• **SCHNEIDER, Michael**
**90571 Schwaig bei Nürnberg (DE)**
• **FRANKE, Jörg**
**91080 Marloffstein (DE)**

(74) Vertreter: **Louis Pöhlau Lohrentz**
**Patentanwälte**
**Merianstrasse 26**
**90409 Nürnberg (DE)**

(56) Entgegenhaltungen:
**WO-A1-2014/094029    AT-B- 390 522**
**DE-A1- 3 907 516**

• YEHUI HAN ET AL: "Evaluation of Magnetic Materials for Very High Frequency Power Applications", IEEE TRANSACTIONS ON POWER ELECTRONICS, INSTITUTE OF ELECTRICAL AND ELECTRONICS ENGINEERS, USA, Bd. 27, Nr. 1, 1. Januar 2012 (2012-01-01), Seiten 425-435, XP011389556, ISSN: 0885-8993, DOI: 10.1109/TPEL.2011.2159995
• NIEDRA J M ET AL: "Improved L-C resonant decay technique for Q measurement of quasilinear power inductors: New results for MPP and ferrite powdered cores", ENERGY CONVERSION ENGINEERING CONFERENCE, 1996. IECEC 96., PROCEEDINGS OF THE 31ST INTERSOCIETY WASHINGTON, DC, USA 11-16 AUG. 1996, NEW YORK, NY, USA,IEEE, US, Bd. 1, 11. August 1996 (1996-08-11), Seiten 566-571, XP010197787, DOI: 10.1109/IECEC.1996.552955 ISBN: 978-0-7803-3547-9
• CLAASSEN ET AL: "A novel technique for measurement of core loss in low permeability materials", JOURNAL OF MAGNETISM AND MAGNETIC MATERIALS, ELSEVIER SCIENCE PUBLISHERS, AMSTERDAM, NL, Bd. 301, Nr. 2, 1. Juni 2006 (2006-06-01), Seiten 541-545, XP024984422, ISSN: 0304-8853, DOI: 10.1016/J.JMMM.2005.09.027 [gefunden am 2006-06-01]

- **Hayrettin Köymen: "Chapter 4 : TUNED CIRCUITS", Course Notes, 1. Januar 2005 (2005-01-01), Seiten 4-1, XP055316462, Gefunden im Internet: URL:http://kilyos.ee.bilkent.edu.tr/~eee21 1/LectureNotes/Chapter%20-%2004.pdf [gefunden am 2016-11-03]**
- **C. F.; FOO, D.; M. ZHANG: "A Resonant Method to Construct Core Loss of Magnetic Materials Using Impedance Analyser", POWER ELECTRONIC SPECIALIST CONFERENCE, 1998, XP002763802, in der Anmeldung erwähnt**

**Beschreibung**

Die Erfindung betrifft ein Messverfahren zur Ermittlung von Verlusten bei Eisenkernen gemäß den Merkmalen des Oberbegriffs des Anspruchs 1.

Ein solches Messverfahren ist aus dem Fachartikel der Autoren C. F. Foo, D. M. Zhang, "A Resonant Method to Construct Core Loss of Magnetic Materials Using Impedance Analyser" bekannt. Der Artikel geht auf einen Vortrag der Power Electronic Specialist Conference 1998 zurück. Er wurde im PESC 98 Record 29th Annual IEEE auf den Seiten 1997 bis 2002 im Jahre 1998 veröffentlicht. In dem Vortrag ist ein Verfahren zur Messung von Verlusten von Eisenkernen beschrieben, bei dem der Eisenkern Teil eines Schwingkreises ist, der mit einer Wechselspannung beaufschlagt wird und über einen Netzwerkanalysator eine Phasenverschiebung der Wechselspannung gemessen wird. Die Phasenverschiebung dient als Maß für die Verluste des Eisenkerns. Nachteilig an diesen Verfahren ist, dass die Phasendifferenz vor allem im Bereich um die Resonanzfrequenz bei geringen Änderungen der Frequenz bereits starken Schwankungen unterworfen ist und eine Messung des Phasenwinkels daher messtechnisch aufwendig ist.

In der Praxis werden die Verluste von Eisenkernen anhand von Stichproben gemessen, indem auf einen aus einer Fertigung entnommenen Eisenkern eine Primär- und eine Sekundärwicklung aufgetragen werden. Das Übertragungsverhalten dieses Transformators wird dann ermittelt, um die Verluste zu bestimmen. Dieses Messverfahren ist relativ zeitaufwendig und für eine lückenlose Erfassung in der Fertigung nicht geeignet.

Aus der DE 39 07 516 A1 ist ein Elektroblechpaket sowie ein Verfahren zur Herstellung eines Elektroblechpakets bekannt. Dieses Elektroblechpaket dient als Stator für einen Elektromotor.

Außerdem werden in der Praxis Elektroblechpakete als Transformatorkerne eingesetzt.

Aus der WO 2014/094029 A1 ist ein Verfahren und eine Vorrichtung zur Bestimmung der magnetischen Eigenschaften eines Blechpakets bekannt.

Aus der AT 390 522 B ist eine Anordnung zur Messung magnetischer Eigenschaften bekannt.

Es ist die Aufgabe der vorliegenden Erfindung, ein Messverfahren zur Bestimmung von Verlusten von Eisenkernen aufzuzeigen, welches eine für industrielle Anwendungen ausreichende Genauigkeit aufweist und gleichzeitig das Messverfahren in kurzer Zeit durchführbar ist, sodass es für industrielle Anwendungen geeignet ist. Insbesondere soll das Messverfahren eine lückenlose Erfassung aller gefertigten Eisenkerne ermöglichen.

Diese Aufgabe wird erfindungsgemäß durch ein Messverfahren mit den Merkmalen des Anspruchs 1 gelöst.

Erfindungsgemäß wird ein Schwingkreis über einen Kondensator, eine Messspule und dem zu messenden Eisenkern, der magnetisch mit der Messspule gekoppelt wird, hergestellt. Dabei wird eine Resonanzfrequenz des Schwingkreises und/oder eine Güte des Schwingkreises gemessen bzw. ermittelt und der Verlust des Eisenkerns auf Basis der gemessenen Resonanzfrequenz und/oder der gemessenen Güte bestimmt.

Das Verfahren sieht vor, dass eine magnetische Kopplung zwischen einer mit einem Kondensator verbundenen Messspule und einem zu messenden Eisenkern hergestellt wird und anschließend die Messspule mit einer Wechselfrequenz beaufschlagt wird, um die Resonanzfrequenz des resultierenden Schwingkreises und/oder die Güte des resultierenden Schwingkreises als Maß für den Verlust des Eisenkerns zu messen.

Eine Messung der Resonanzfrequenz des Schwingkreises kann mit ausreichender Genauigkeit durchgeführt werden. Auch eine Messung der Güte des Schwingkreises kann mit hinreichender Genauigkeit ausgeführt werden. Es hat sich überraschenderweise gezeigt, dass die Resonanzfrequenz wie auch die Güte jeweils ein taugliches Maß darstellen, um die Verluste von Eisenkernen zu bestimmen. Die Messung kann entweder nur auf Basis einer Resonanzfrequenzbestimmung oder nur auf Basis einer Gütebestimmung oder auf Basis einer Kombination von Resonanzfrequenzbestimmung und Gütebestimmung erfolgen.

Durch die magnetische Kopplung der Messspule mit dem Eisenkern wird der Eisenkern ein Teil des resultierenden Schwingkreises. Die Verluste bei Eisenkernen haben infolge der magnetischen Kopplung zwischen der Messspule und dem zu messenden Eisenkern einerseits Einfluss auf die Resonanzfrequenz des resultierenden Schwingkreises, indem die mit der Messspule gekoppelten Eisenkerne je nach Verluste deren Impedanz beeinflussen sowie andererseits Einfluss auf die Güte des resultierenden Schwingkreises, indem bei höheren Verlusten des Eisenkerns die Güte des resultierenden Schwingkreises abnimmt.

Unter einem Eisenkern sind solche magnetisch leitfähigen Kerne zu verstehen, die als Kern einer Wicklung oder Spule dienen und für elektrische Maschinen, beispielsweise Motoren oder Transformatoren, verwendet werden. Solche Eisenkerne oder Transformatorkerne bestehen in der Regel aus ferromagnetischen Werkstoffen. Es werden lamellierte Eisenkerne verwendet, die einen geblechten Kern aufweisen, der aus einer Mehrzahl von gestapelten Transformatorblechen oder Elektroblechen besteht. Die einzelnen Bleche sind voneinander elektrisch isoliert und werden zu einem Elektroblechstapel gestapelt und mechanisch verbunden. Die Isolierung ist zur Vermeidung von Wirbelstromverlusten erforderlich. In der Fertigung ergibt sich eine Streuung solcher Eisenkerne, beispielsweise durch fehlerhafte Isolierungen oder Abweichungen in den verwendeten Eisenlegierungen. Im Rahmen einer Qualitätssicherung ist es erforderlich, diese Verluste messtechnisch zu erfassen.

Unter Resonanzfrequenz versteht man diejenige Frequenz der Wechselspannung, bei der der gebildete Schwingkreis in Resonanz ist. Die Resonanzfrequenz eines Schwingkreises lässt sich mit der folgenden Gleichung ermitteln:

$$f_{res} = \frac{1}{2\pi\sqrt{LC}}$$

fres: Resonanzfrequenz
L: Induktivität
C: Kapazität

Die Güte eines Schwingkreises ergibt sich als Verhältnis der Resonanzfrequenz zu der Bandbreite:

$$Q = \frac{f_0}{B}$$

Q: Güte
B: Bandbreite
$f_0$: Resonanzfrequenz

Der Kehrwert der Güte eines Schwingkreises wird auch als Dämpfung bezeichnet. Die Dämpfung eines Schwingkreises ist umso höher je höher die Verluste sind. Die Bandbreite der Übertragungscharakteristik eines Schwingkreises ist in der Regel symmetrisch um die Resonanzfrequenz.

Es kann vorgesehen sein, dass zur Messung der Bandbreite der Übertragungscharakteristik eine erste Frequenz $f_1$ unterhalb der Resonanzfrequenz und eine zweite Frequenz $f_2$ oberhalb der Resonanzfrequenz bestimmt wird, bei der die Übertragungscharakteristik des Schwingkreises jeweils die gleiche Amplitude aufweist. Vorteilhafterweise kann ein Abfall der Amplitude der Übertragungscharakteristik von der Resonanzfrequenz zu $f_1$ und $f_2$ um einen festen Wert, vorzugsweise ein Abfall in Höhe von 3dB oder 6dB herangezogen werden. Durch Messung dieser beiden Frequenzen $f_1$ bzw. $f_2$ kann die Güte des resultierenden Schwingkreises in ausreichender Genauigkeit bestimmt werden.

Die Resonanzfrequenz eines Schwingkreises hängt unmittelbar von der Induktivität L und der Kapazität C des Schwingkreises ab. Durch Ändern der Induktivität L oder der Kapazität C wird die Resonanzfrequenz direkt beeinflusst.

Die Bestimmung der Resonanzfrequenz kann in einer Ausgestaltung dadurch erfolgen, dass der Schwingkreis bestehend aus der Messspule, dem Kondensator und dem angekoppelten Eisenkern mit einer Wechselspannung im Bereich der voraussichtlichen Resonanzfrequenz beaufschlagt wird. Anschließend kann der Schwingkreis durch Variation des Kondensatorwerts auf Resonanz abgestimmt werden. Aus dem Differenzwert der Kapazität des Kondensators kann auf den durch den Verlust behafteten Eisenkern hervorgerufenen Differenzwert der Induktivität und damit der Veränderung der Reluktanz des Schwingkreises zurückgerechnet werden. Dies ist ein direktes Maß für die Verluste in dem Eisenkern.

In einer Ausgestaltung kann vorgesehen sein, dass die Frequenz der Wechselspannung verändert wird, um den Schwingkreis auf Resonanz abzustimmen bzw. die Resonanzfrequenz zu ermitteln. Hier ist die Frequenzänderung bzw. die Abweichung der gemessenen Frequenz von einer voraussichtlichen Resonanzfrequenz ein Maß für die durch den Verlust behafteten Eisenkern veränderte Induktivität und damit wiederum für die Verluste des Eisenkerns.

Um den Bereich der voraussichtlichen Resonanzfrequenz bestimmen zu können, kann vorgesehen sein, dass zu Beginn des Messverfahrens, vorzugsweise in einem vorbereitenden Schritt, eine Referenzmessung mit einem Referenzeisenkern durchgeführt wird, um die voraussichtliche Resonanzfrequenz des Schwingkreises zu bestimmen. Alternativ kann die voraussichtliche Resonanzfrequenz auch rechnerisch über eine rechnerische Simulation des resultierenden Schwingkreises ermittelt werden. Die voraussichtliche Resonanzfrequenz kann in dem Messverfahren als Referenzwert bzw. als Standard für einen Eisenkern mit geringen Verlusten verwendet werden.

Magnetische Kopplung zwischen Spule und Eisenkern bedeutet, dass die Messspule räumlich in die Nähe des Eisenkerns gebracht wird oder dass der Eisenkern räumlich in die Nähe der Messspule gebracht wird, sodass der magnetische Fluss der Spule zumindest zu einem großen Teil, vorzugsweise möglichst zu mehr als 50% oder zu mehr als 75% oder möglichst vollständig, durch den zu messenden Eisenkern geleitet wird. Dabei kann die Messspule in einem Bereich außen an den zu messenden Eisenkern angenähert oder angelegt werden. Vorzugsweise kann vorgesehen sein, dass die magnetische Kopplung durch Einbringung der Messspule in einen Innenraum des Eisenkerns hergestellt wird.

Um eine hohe Qualität der Messergebnisse zu erzielen, kann vorgesehen sein, mehrere Messdurchgänge zu einem Eisenkern durchzuführen. Insbesondere kann vorgesehen sein, dass die Resonanzfrequenz und/oder die Güte des Schwingkreises in unterschiedlichen Winkelpositionen der Messspule relativ zu dem Eisenkern gemessen werden, oder dass während der Messung der Resonanzfrequenz und/oder der Güte die Winkelposition der Messspule relativ zu dem Eisenkern variiert wird.

Ein Gedanke der Erfindung sieht vor, das erfindungsgemäße Messverfahren mittels einer Messvorrichtung durchzuführen. Dabei kann vorgesehen sein, dass die Messvorrichtung eine Bedien- und/oder Anzeigevorrichtung zur Anzeige von Messergebnissen aufweist sowie einen Wechselspannungsgenerator und eine Messspule zur Durchführung der Messung umfasst.

Die Messspule kann mit einem Kondensator zu einem Parallelschwingkreis verschaltet sein. Alternativ kann die Messspule mit einem Kondensator zu einem Serienschwingkreis verschaltet sein.

In einer Ausgestaltung kann vorgesehen sein, dass der Kondensator als automatisch abstimmbarer Kondensator ausgebildet ist oder einen abstimmbaren Kondensator aufweist. Der abstimmbare Kondensator kann insbesondere als Drehkondensator ausgebildet sein. Um den Kondensator automatisch abzustimmen kann der Rotor des Kondensators mit einem Schrittmotor oder einem Servomotor mechanisch verbunden sein. In einer Ausgestaltung kann vorgesehen sein, dass der Kondensator als Kapazitätsdiode ausgebildet ist oder eine Kapazitätsdiode aufweist.

Um eine besonders hohe Messqualität zu erreichen kann vorgesehen sein, dass der Kondensator eine hohe Güte aufweist. Hierzu kann beispielsweise ein Glimmerkondensator oder ein Luftkondensator verwendet werden.

In einer Ausgestaltung kann vorgesehen sein, dass die Messvorrichtung einen Netzwerkanalysator umfasst, der mit dem Schwingkreis, vorzugsweise der Messspule und/oder dem Kondensator verbunden ist, um die Resonanzfrequenz und/oder die Güte des Schwingkreises zu messen.

Netzwerkanalysatoren, die kommerziell erhältlich sind, erfassen in der Regel einen Frequenzbereich der bei ca. 9 kHz startet und teilweise bis weit in den MHz-Bereich reicht. Es hat sich herausgestellt, dass der für die vorliegende Messung vorteilhafte Frequenzbereich der Wechselspannung in einem Bereich zwischen 5 kHz und 50 kHz, bevorzugt zwischen 9 kHz und 20 kHz liegt.

Um störende Einflüsse durch die Anschlussimpedanz des Netzwerkanalysators oder einer sonstigen Anschlussvorrichtung zu vermeiden, kann vorgesehen sein, dass der Schwingkreis über eine Schaltung zur Impedanzanpassung angeschlossen ist. Vorzugsweise dass zwischen dem Schwingkreis und dem Netzwerkanalysator eine Schaltung zur Impedanzanpassung geschaltet ist.

Um eine hohe Reproduzierbarkeit der Messergebnisse zu gewährleisten, kann vorgesehen sein, dass die Messvorrichtung eine Aufnahmevorrichtung zur Halterung eines Eisenkerns und/oder der Messspule aufweist. Sowohl der Eisenkern als auch die Messspule können in der Aufnahmevorrichtung in definierter Position und Abstand zueinander positioniert werden. Die Aufnahmevorrichtung gewährleistet, dass die Position der Messspule und des Eisenkerns zueinander immer gleich ausgestaltet ist. Somit können Abweichungen des Messergebnisses aufgrund von Lagetoleranzen weitgehend ausgeschlossen werden.

Um eine Messung in unterschiedlichen Positionen zu ermöglichen, kann vorgesehen sein, dass die Aufnahmevorrichtung einen Aktor zum Drehen des Eisenkerns aufweist, um eine Messung in unterschiedlichen Winkelpositionen zwischen der Messspule und dem Eisenkern zu ermöglichen. Die Messung kann in unterschiedlichen Winkelpositionen erfolgen, indem beispielsweise der Eisenkern und/oder die Messspule in unterschiedliche Winkelpositionen gedreht werden und an den unterschiedlichen Winkelpositionen jeweils eine Messung durchgeführt wird. Alternativ kann auch vorgesehen sein, dass eine Messung während einer Drehung des Eisenkerns und/oder während einer Drehung der Messspule erfolgt.

Um einen automatischen Messablauf zu ermöglichen, kann vorgesehen sein, dass die Aufnahmevorrichtung einen Aktor zum Drehen der Messspule aufweist, um eine Messung in unterschiedlichen Winkelpositionen zwischen der Messspule und dem Eisenkern zu ermöglichen.

Ein genaues Messergebnis lässt sich erzielen, indem die Messspule als Luftspule ausgebildet ist. Eine Luftspule besitzt eine hohe Güte, sodass diese als Messspule besonders geeignet ist.

Um die Messgenauigkeit weiter zu erhöhen, kann vorgesehen sein, dass die Messspule als abgeschirmte Luftspule ausgebildet ist. Durch die Abschirmung werden Störeinflüsse durch magnetische oder elektrische Störfelder weitgehend unterdrückt.

In einer Ausgestaltung kann vorgesehen sein, dass zur Unterdrückung von Störfeldern die Aufnahmevorrichtung eine Abschirmvorrichtung aufweist, um den Eisenkern und/oder die Messspule abzuschirmen.

Eine Erhöhung der Messgenauigkeit ergibt sich, indem in einer Ausgestaltung vorgesehen ist, dass die Messvorrichtung einen Temperaturfühler aufweist und so ausgebildet ist, dass sie die von Temperaturschwankungen hervorgerufenen Messwertabweichungen automatisch korrigiert. Elektronische Schwingkreise, vor allem LC-Schwingkreise, weisen einen relativ hohen Temperaturkoeffizienten auf. Über die Messung der Temperatur mittels eines Temperaturfühlers ist die Messvorrichtung in der Lage, diesen Temperaturkoeffizienten automatisch auszugleichen.

Eine erfindungsgemäße Umsetzung der Erfindung sieht ein Herstellverfahren für Elektroblechpakete vor, wobei einzelne Elektroblechlamellen mit einer Isolierung versehen und zu Elektroblechpaketen gestapelt werden. Anschließend werden die Verluste eines solchen Elektroblechstapels gemessen. Das erfindungsgemäße Messverfahren besitzt den Vorteil, dass die Messung während der Fertigung solcher Elektroblechpakete noch innerhalb der Fertigungslinie erfolgen kann.

Im Rahmen der Fertigung der Elektroblechpakete werden Elektroblechlamellen von größeren Blechen abgetrennt. Durch diese Trennverfahren können an den Schnittkanten Grate entstehen, welche unter Umständen elektrische Kontakte zwischen Einzelblechen verursachen. Dies hat erhöhte Wirbelströme und damit erhöhte Verluste des Eisenkerns zur Folge. Es ist unter Anderem Ziel der Erfindung, solche erhöhten Verluste zu erfassen. Dadurch ist z.B. möglich, zu erkennen, ob entsprechende Bestandswerkzeuge ihre Verschleißgrenze erreicht bzw. überschritten haben und ausgetauscht werden müssen.

Insbesondere ist vorgesehen, dass die Verluste eines Elektroblechpakets gemessen werden, bevor das Elektroblechpaket mit einer Wicklung versehen wird. Dies bietet gegenüber dem in der Praxis angewandten Messverfahren den Vorteil, dass eine Wicklung auf dem Blechpaket nicht erfolgen muss, um die Messung durchzuführen. Dies bedeutet einen erheblichen Zeitgewinn durch das erfindungsgemäße Messverfahren.

Um eine hohe Fertigungsqualität sicherzustellen, kann vorgesehen sein, dass für die Verluste eines Elektroblechpakets ein Grenzwert festgelegt wird und diejenigen Elektroblechpakete, deren Verluste den Grenzwert überschreiten, als fehlerhaft gekennzeichnet werden und/oder aussortiert werden.

Eine Dokumentation der Fertigungsqualität kann erzielt werden, indem vorgesehen ist, dass zur Qualitätssicherung zu jedem gemessenen Elektroblechpaket der gemessene Verlustwert abgespeichert wird und mehrere Messwerte statistisch ausgewertet werden. Beispielsweise kann jede zu fertigende Charge gemeinsam erfasst werden und die Messergebnisse einer Charge gesammelt und statistisch ausgewertet und dokumentiert werden. Somit kann bei jeder zu fertigenden Charge die hohe Qualität der Fertigung dokumentiert werden.

Weitere Ausgestaltungen der Erfindung sind in den Figuren gezeigt und nachfolgend beschrieben. Dabei zeigen:

Fig. 1: ein schematisches Blockschaltbild einer erfindungsgemäßen Messvorrichtung;

Fig. 2: einen schematischen Aufbau einer Messspule im Innenraum eines Eisenblechpakets;

Fig. 3: eine Frequenzübertragungscharakteristik mit Bestimmung des 3dB-Punktes;

Fig. 4: Abweichungen in dem Frequenzgang eines Schwingkreises infolge einer Impedanzänderung der Spule;

Fig. 5: Einfluss der Güte eines Schwingkreises auf die Übertragungscharakteristik.

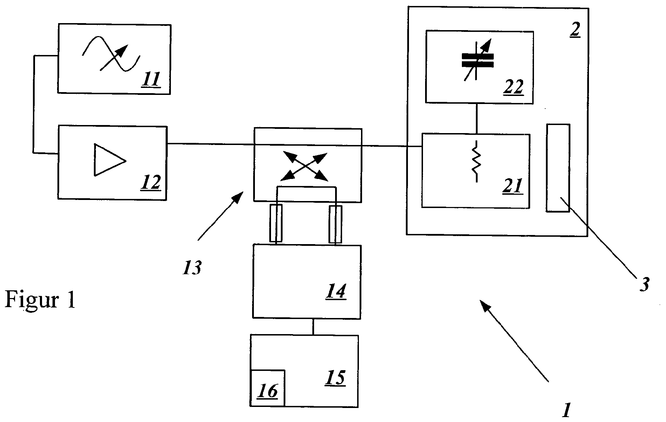

Die Fig. 1 zeigt ein schematisches Blockschaltbild einer Messvorrichtung 1. Ein Wechselspannungsgenerator 11, dessen Wechselspannung einstellbar ist, speist über einen Verstärker 12 eine Messspule 21. Die Messspule 21 ist mit einem abstimmbaren Kondensator 22 verbunden. Die Messspule 21 ist mit einem Eisenkern 3 magnetisch gekoppelt. Die Messspule 21, der variable Kondensator 22 sowie der Eisenkern 3 bilden zusammen einen Schwingkreis 2 aus.

Ein Netzwerkanalysator 14 ist über eine Ankoppelschaltung 13, die der Impedanzanpassung dient, mit dem Schwingkreis 2 verbunden. Der Netzwerkanalysator 14 besitzt eine Bedien- und Anzeigevorrichtung 15, um Messergebnisse darzustellen.

In der Bedien- und Anzeigevorrichtung ist ein Temperaturfühler 16 angeordnet, um die Umgebungstemperatur zu messen. Anhand der Temperaturmessung können Temperaturschwankungen erfasst und rechnerisch ausgeglichen werden.

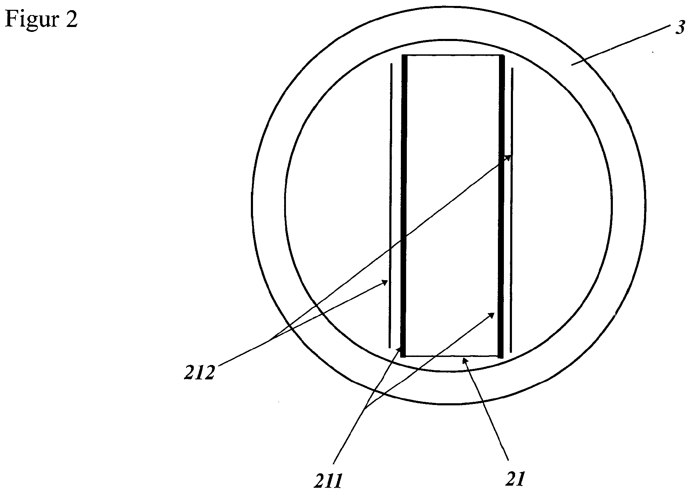

In der Fig. 2 ist schematisch die Platzierung der Messspule 21 in einem Eisenblechkern 3 dargestellt. Der Eisenblechkern 3 in Fig. 2 ist als Ringkern ausgebildet. Alternativ ist auch möglich, einen herkömmlichen EI-Kern oder andere geometrische Kernformen zu verwenden und auszumessen.

Die Messspule 21 ist als Luftspule ausgebildet und besitzt eine Draht-Wicklung 211. Diese Wicklung kann beispielsweise aus einem isolierten Kupferlackdraht bestehen. Seitlich der Messspule ist eine Abschirmung 212 angeordnet, die dafür sorgt, dass der magnetische Fluss der Spule in den Eisenkern 3 geleitet wird. Über eine in der Fig. 2 nicht dargestellte elektrische Verbindung ist die Eisenspule 21 mit der Messvorrichtung 1 elektrisch verbunden.

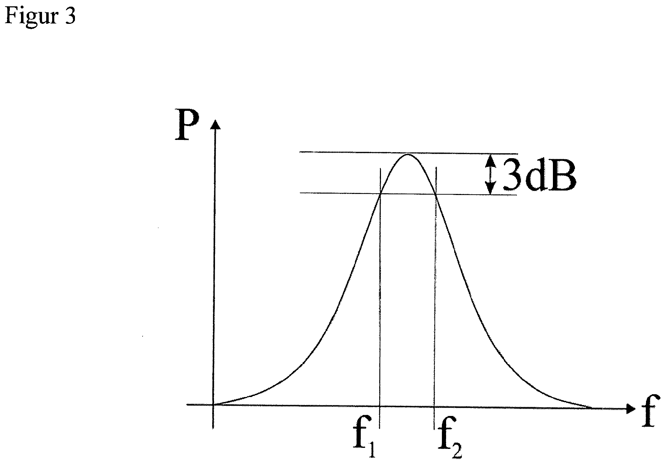

In der Fig. 3 ist ein Frequenzgang des Schwingkreises 2 beispielhaft dargestellt. In dem dargestellten Beispiel handelt es sich um die Frequenzübertragungscharakteristik eines zu einem Parallelschwingkreis verschalteten LC-Kreises. Auf der X-Achse ist der Frequenzbereich aufgetragen. Die Y-Achse zeigt die Amplitude der resultierenden Wechselspannung an dem Schwingkreis selbst. Der Bereich der Resonanzfrequenz ist durch die höchste Amplitude abzulesen.

Die in der Fig. 3 bezeichneten Frequenzen $f_1$ und $f_2$ bezeichnen diejenigen Frequenzen, bei denen die Amplitude zu beiden Seiten der Resonanzfrequenz um 3dB abgefallen ist. Diese sog. 3dB-Bandbreite kann über den Netzwerkanalysator einfach ausgemessen werden. Diese Bandbreite ist ein direktes Maß für die Güte des Schwingkreises und damit für die Verluste des jeweiligen Eisenkerns. Je schmäler diese Bandbreite im Vergleich zu der Resonanzfrequenz ist, d.h. je enger die Frequenzen $f_1$ und $f_2$ beieinander liegen, desto höher ist die Güte des Schwingkreises und desto geringer sind die Verluste des Eisenkerns. Sofern die Verluste des Eisenkerns ansteigen, erhöht sich also auch die Bandbreite des Schwingkreises. Dies kann durch eine Zunahme der Differenz der Frequenzen $f_2 - f_1$ einfach bestimmt werden.

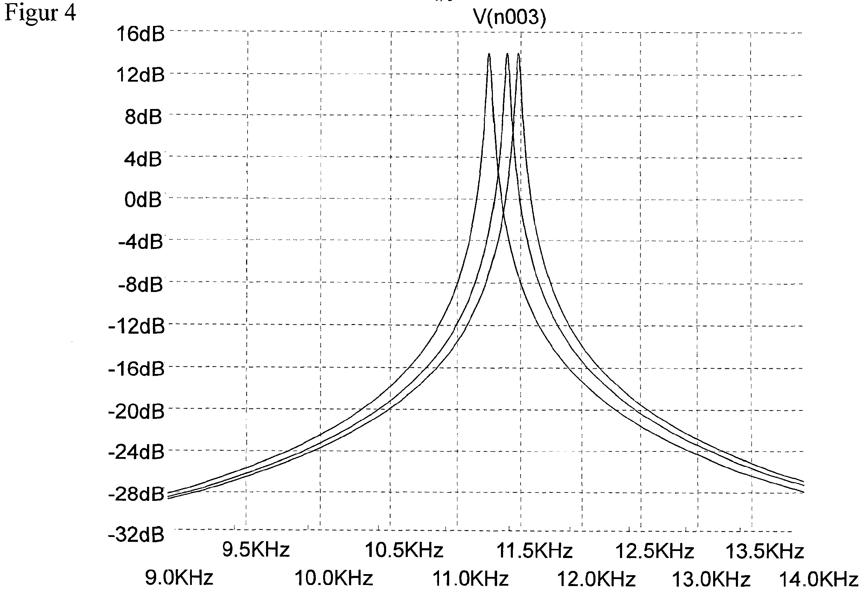

In der Fig. 4 ist beispielhaft ein Schaubild für den Einfluss einer Änderung der Impedanz auf die Resonanzfrequenz eines Schwingkreises dargestellt. Eine Erhöhung der Impedanz der Spule in einem Schwingkreis führt zu einer Verringerung der Resonanzfrequenz.

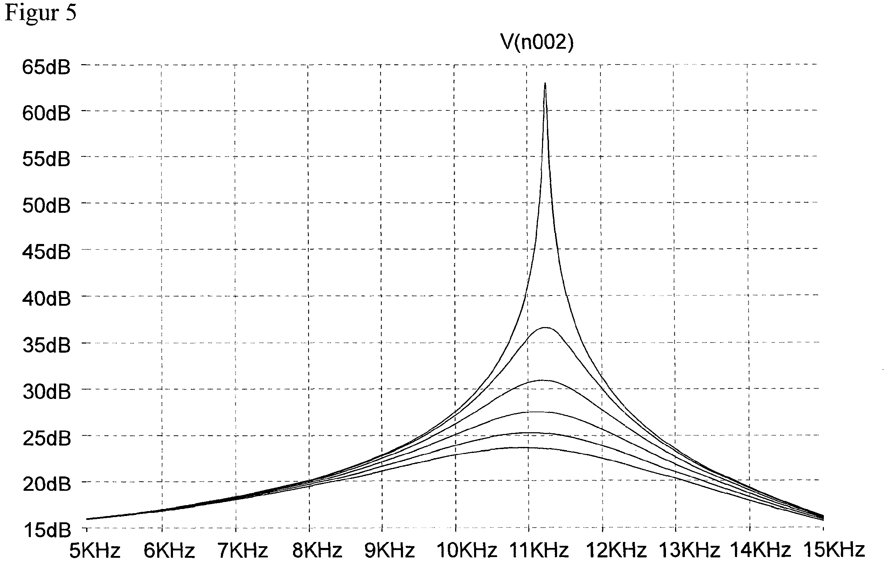

In der Fig. 5 ist beispielhaft ein Schaubild einer Frequenzübertragungscharakteristik eines gedämpften Schwingkreises bei unterschiedlichen Dämpfungen dargestellt. Je größer die Dämpfung des Schwingkreises ausfällt, desto geringer ist die Resonanzüberhöhung im Bereich der Resonanzfrequenz. Diese Abweichung in der Resonanzüberhöhung ist ebenfalls messtechnisch leicht zu ermitteln.

Auf Basis der veränderten Güte (Q) und der Änderung der Resonanzfrequenz stehen bei dem erfindungsgemäßen Messverfahren zwei messtechnisch einfach zugängliche Faktoren zur Verfügung, um die Verluste in einem Eisenkern mit hoher Genauigkeit zu bestimmen.

Bezugszeichenliste

| 1 | Messvorrichtung |
| 11 | Wechselfrequenzgenerator / Hochfrequenzgenerator |
| 12 | Verstärker |
| 13 | Koppelschaltung |
| 14 | Netzwerkanalysator |
| 15 | Bedien- und/oder Anzeigevorrichtung |
| 16 | Temperaturfühler |
| 2 | Schwingkreis |
| 21 | Messspule |
| 211 | Wicklung |
| 212 | Schirmung |
| 22 | abstimmbarer Kondensator |
| 3 | Eisenkern / Elektroblechpaket |
| $f_1$, $f_2$ | Frequenz des 3dB-Punkts |

**Patentansprüche**

1. Messverfahren zur Ermittlung von Verlusten bei lamellierten Eisenkernen (3), wobei eine magnetische Kopplung zwischen einer mit einem Kondensator (21) zu einem Schwingkreis (2) verbundenen Messspule (21) und einem lamellierten Eisenkern (3) hergestellt wird und anschließend die Messspule (21) mit einer Wechselspannung beaufschlagt wird,

   **dadurch gekennzeichnet,**
   **dass** eine Resonanzfrequenz des Schwingkreises (2) und/oder eine Güte des Schwingkreises (2) gemessen wird und der Verlust des lamellierten Eisenkerns (3) anhand der gemessenen Resonanzfrequenz und/oder der gemessenen Güte bestimmt wird, und
   **dass** die Resonanzfrequenz des Schwingkreises (2) durch Veränderung der Kapazität des Kondensators (22) oder durch Veränderung der Frequenz der Wechselspannung gemessen wird.

2. Messverfahren nach Anspruch 1,

   **dadurch gekennzeichnet,**
   **dass** die Güte des Schwingkreises (2) durch Messung der Bandbreite einer Frequenzübertragungscharakteristik des Schwingkreises (2) gemessen wird, vorzugsweise durch Bestimmung einer ersten Frequenz ($f_1$) oberhalb und einer zweiten Frequenz ($f_2$) unterhalb der Resonanzfrequenz des Schwingkreises (2) bei denen die Amplitude der Wechselspannung jeweils gleich groß ist,
   vorzugsweise, dass die Güte des Schwingkreises (2) durch Messung der 3dB-Bandbreite oder der 6dB-Bandbreite bestimmt wird.

3. Messverfahren nach Anspruch 1 oder 2,
   **dadurch gekennzeichnet,**
   **dass** die magnetische Kopplung durch Einbringung der Messspule (21) in einen Innenraum des lamellierten Eisenkerns (3) hergestellt wird.

4. Messverfahren nach einem der vorhergehenden Ansprüche,

   **dadurch gekennzeichnet,**
   **dass** die Resonanzfrequenz und/oder die Güte des Schwingkreises (2) in unterschiedlichen Winkelpositionen der Messspule (21) relativ zu dem lamellierten Eisenkern (3) gemessen wird, oder

   **dass** während der Messung der Resonanzfrequenz und/oder der Güte die Winkelposition der Messspule (21) relativ zu dem lamellierten Eisenkern variiert wird.

5. Messvorrichtung ausgebildet ein Messverfahren nach einem der vorhergehenden Ansprüche durchzuführen, wobei die Messvorrichtung (1) eine Bedien- und/oder Anzeigevorrichtung zur Anzeige von Messergebnissen, sowie einen Wechselspannungsgenerator (11) und eine Messspule (21) umfasst,
   wobei die Messspule (21) mit einem Kondensator (22) zu einem Parallelschwingkreis oder einem Serienschwingkreis verschaltet ist.

6. Messvorrichtung nach Anspruch 5,
   **dadurch gekennzeichnet,**
   **dass** der Kondensator (22) als automatisch abstimmbarer Kondensator ausgebildet ist, insbesondere als Drehkondensator oder als Kapazitätsdiode ausgebildet ist.

7. Messvorrichtung nach Anspruch 5 oder 6,
   **dadurch gekennzeichnet,**
   **dass** die Messvorrichtung (1) einen Netzwerkanalysator (14) umfasst, der mit dem Schwingkreis (2), vorzugsweise der Messspule (21) und/oder dem Kondensator (22) verbunden ist, um die Resonanzfrequenz und/oder die Güte des Schwingkreises (2) zu messen, vorzugsweise, dass der Schwingkreis (2) über eine Schaltung zur Impedanzanpassung (13) angeschlossen ist, weiter vorzugsweise, dass zwischen dem Schwingkreis (2) und dem Netzwerkanalysator (14) eine Schaltung zur Impedanzanpassung (13) geschaltet ist.

8. Messvorrichtung nach einem der Ansprüche 5 bis 7, **dadurch gekennzeichnet,** **dass** die Messvorrichtung (1) eine Aufnahmevorrichtung zur Halterung eines lamellierten Eisenkerns (3) und/oder der Messspule (21) aufweist, dass die Aufnahmevorrichtung vorzugsweise einen Aktor zum Drehen des lamellierten Eisenkerns (3) aufweist, um eine Messung in unterschiedlichen Winkelpositionen zwischen der Messspule (21) und dem lamellierten Eisenkern (3) zu ermöglichen, und/oder einen Aktor zum Drehen der Messspule (21) aufweist, um eine Messung in unterschiedlichen Winkelpositionen zwischen der Messspule (21) und dem lamellierten Eisenkern (3) zu ermöglichen.

9. Messvorrichtung nach einem der Ansprüche 5 bis 8, **dadurch gekennzeichnet,** **dass** die Messspule (21) als Luftspule, vorzugsweise als abgeschirmte Luftspule (21), ausgebildet ist.

10. Messvorrichtung nach einem der Ansprüche 5 bis 9, **dadurch gekennzeichnet,** **dass** die Aufnahmevorrichtung eine Abschirmvorrichtung aufweist, um den lamellierten Eisenkern (3) und/oder die Messspule (21) abzuschirmen.

11. Messvorrichtung nach einem der Ansprüche 5 bis 10, **dadurch gekennzeichnet,** **dass** die Messvorrichtung (1) einen Temperaturfühler aufweist und so ausgebildet ist, dass sie die von Temperaturschwankungen hervorgerufenen Messwertabweichungen automatisch korrigiert.

12. Herstellverfahren für Elektroblechpakete (3), wobei einzelne Elektroblechlamellen mit einer Isolierung versehen und zu Elektroblechpaketen (3) gestapelt werden und anschließend die Verluste eines solchen Elektroblechpakets mit einer Messvorrichtung nach einem der Ansprüche 5 bis 11 gemessen werden, wobei vorzugsweise die Verluste eines Elektroblechpakets (3) gemessen werden, bevor das Elektroblechpaket (3) mit einer Wicklung versehen wird.

13. Herstellverfahren nach Anspruch 12, **dadurch gekennzeichnet,** **dass** für die Verluste eines Elektroblechpakets (3) ein Grenzwert festgelegt wird und diejenigen Elektroblechpakete (3), deren Verluste den Grenzwert überschreiten, als fehlerhaft gekennzeichnet werden und/oder aussortiert werden.

14. Herstellverfahren nach Anspruch 12 oder 13, **dadurch gekennzeichnet,**

**dass** zur Qualitätssicherung zu jedem gemessenen Elektroblechpaket (3) der gemessene Verlustwert abgespeichert wird und mehrere Messwerte statistisch ausgewertet werden.

## Claims

1. Measuring method for ascertaining losses in slatted iron cores (3), wherein a magnetic coupling between a measuring coil (21), connected to a capacitor (21) to form an resonant circuit (2), and a slatted iron core (3) is produced, and the measuring coil (21) is then supplied with an alternating voltage, **characterised in that** a resonance frequency of the resonant circuit (2) and/or a quality of the resonant circuit (2) is measured, and the loss of the slatted iron core (3) is determined by means of the measured resonance frequency and/or the measured quality, and the resonance frequency of the resonant circuit (2) is measured by changing the capacity of the capacitor (22) or by changing the frequency of the alternating current.

2. Measuring method according to claim 1,

   **characterised in that** the quality of the resonant circuit (2) is measured by measuring the bandwidth of a frequency transmission characteristic of the resonant circuit (2), preferably by determining a first frequency (f1) above and a second frequency (f2) below the resonance frequency of the oscillating circuit (2) in which the amplitude of the alternating current is respectively the same size, preferably, the quality of the oscillating circuit (2) is determined by measuring the 3dB bandwidth or the 6dB bandwidth.

3. Measuring method according to claim 1 or 2, **characterised in that** the magnetic coupling is produced by introducing the measuring coil (21) into an interior chamber of the slatted iron core (3).

4. Measuring method according to one of the preceding claims, **characterised in that** the resonance frequency and/or the quality of the resonant circuit (2) is measured in different angle positions of the measuring coil (21) in relation to the slatted iron core (3), or when measuring the resonance frequency and/or the quality, the angle position of the measuring coil (21) in relation to the slatted iron core is varied.

5. Measuring device designed to carry out a measuring method according to one of the preceding claims, wherein the measuring device (1) comprises an operating and/or display device for displaying measuring results, and an alternating current generator (11) and a measuring coil (21), wherein the measuring coil (21) is switched with a capacitor (22) to form a parallel resonant circuit or a series resonant circuit.

6. Measuring device according to claim 5,
**characterised in that**
the capacitor (22) is formed as an automatically tuneable capacitor, in particular as a variable capacitor or as a capacitance diode.

7. Measuring device according to claim 5 or 6,
**characterised in that**
the measuring device (1) comprises a network analyser (14), which is connected to the resonant circuit (2), preferably the measuring coil (21) and/or the capacitor (22), in order to measure the resonance frequency and/or the quality of the resonant circuit (2), preferably, the resonant circuit (2) is attached via circuitry for adjusting impedance (13), further preferably circuitry for adjusting impedance (13) is switched between the resonant circuit (2) and the network analyser (14).

8. Measuring device according to one of claims 5 to 7,
**characterised in that**
the measuring device (1) has a receiving device for holding a slatted iron core (3) and/or the measuring coil (21), the receiving device preferably has an actuator for rotating the slatted iron core (3), in order to enable a measuring in different angle positions between the measuring coil (21) and the slatted iron core (3), and/or has an actuator for rotating the measuring coil (21), in order to enable a measuring in different angle positions between the measuring coil (21) and the slatted iron core (3).

9. Measuring device according to one of claims 5 to 8,
**characterised in that**
the measuring coil (21) is formed as an air coil, preferably as a shielded air coil (21).

10. Measuring device according to one of claims 5 to 9,
**characterised in that**
the receiving device has a shielding device, in order to shield the slatted iron core (3) and/or the measuring coil (21).

11. Measuring device according to one of claims 5 to 10,
**characterised in that**
the measuring device (1) has a temperature sensor and is formed in such a way that it automatically corrects the measurement deviations caused by temperature fluctuations.

12. Production method for electrical steel packets (3), wherein individual electrical steel lamellae are provided with an insulation and are stacked to form electrical steel packets (3), and the losses of such an electrical steel packet are then measured with a measuring device according to one of claims 5 to 11, wherein the losses of an electrical steel packet (3) are preferably measured before the electrical steel packet (3) is provided with a winding.

13. Production method according to claim 12,
**characterised in that**
a threshold value is set for the losses of an electrical steel packet (3), and the electrical steel packets (3) whose losses exceed the threshold value are characterised as erroneous and/or eliminated.

14. Production method according to claim 12 or 13,
**characterised in that**
the measured loss value is stored for ensuring the quality of each measured electrical steel packet (3), and several measurements are statistically analysed.

**Revendications**

1. Procédé de mesure pour la détermination des pertes dans un noyau de fer lamellé (3), dans lequel un couplage magnétique est établi entre une bobine de mesure (21) reliée à un condensateur (21) afin d'obtenir un circuit résonnant (2) et un noyau de fer lamellé (3) et la bobine de mesure (21) est alimentée avec une tension alternative,

    **caractérisé en ce que**
    une fréquence de résonance du circuit résonnant (2) et/ou une qualité du circuit résonnant (2) est mesurée et la perte du noyau de fer lamellé (3) est déterminée à l'aide de la fréquence de résonance mesurée et/ou de la qualité mesurée et
    la fréquence de résonance du circuit résonnant (2) est mesurée en modifiant la capacité du condensateur (22) ou en modifiant la fréquence de la tension alternative.

2. Procédé de mesure selon la revendication 1,

    **caractérisé en ce que**
    la qualité du circuit résonnant (2) est mesurée en mesurant la largeur de bande d'une caractéristique de transmission de fréquence du circuit résonnant (2), de préférence en déterminant une première fréquence ($f_1$) au-dessus et une deuxième fréquence (f2) en dessous de la fréquence de résonance du circuit résonnant (2), pour lesquelles l'amplitude de la tension alternative présente la même valeur,
de préférence, la qualité du circuit résonnant (2) est déterminée en mesurant la largeur de bande à 3 dB ou la largeur de bande à 6 dB.

3. Procédé de mesure selon la revendication 1 ou 2, **caractérisé en ce que**
le couplage magnétique est établi en insérant la bobine de mesure (21) dans un espace interne du noyau de fer lamellé (3).

4. Procédé de mesure selon l'une des revendications précédentes,

**caractérisé en ce que**
la fréquence de résonance et/ou la qualité du circuit résonnant (2) est mesurée pour différentes positions angulaires de la bobine de mesure (21) par rapport au noyau de fer lamellé (3) ou **en ce que**, pendant la mesure de la fréquence de résonance et/ou de la qualité, la position angulaire de la bobine de mesure (21) par rapport au noyau de fer lamellé varie.

5. Dispositif de mesure conçu pour exécuter un procédé de mesure selon l'une des revendications précédentes, dans lequel le dispositif de mesure (1) comprend un dispositif de commande et/ou d'affichage pour l'affichage de résultats de mesure, ainsi qu'un générateur de tension alternative (11) et une bobine de mesure (21),
dans lequel la bobine de mesure (21) est branchée avec un condensateur (22) afin d'obtenir un circuit résonnant en parallèle ou un circuit résonnant en série.

6. Dispositif de mesure selon la revendication 5, **caractérisé en ce que**
le condensateur (22) est conçu comme un condensateur accordable automatiquement, plus particulièrement comme un condensateur variable ou comme une diode varicap.

7. Dispositif de mesure selon la revendication 5 ou 6, **caractérisé en ce que**
le dispositif de mesure (1) comprend un analyseur de réseau (14), qui est relié avec le circuit résonnant (2), de préférence la bobine de mesure (21) et/ou le condensateur (22), afin de mesurer la fréquence de résonance et/ou la qualité du circuit résonnant (2), de préférence **en ce que** le circuit résonnant (2) est raccordé par l'intermédiaire d'un circuit d'adaptation d'impédance (13), de préférence **en ce que**, entre le circuit résonnant (2) et l'analyseur de réseau (14), est branché un circuit pour l'adaptation d'impédance (13).

8. Dispositif de mesure selon l'une des revendications 5 à 7,
**caractérisé en ce que**
le dispositif de mesure (1) comprend un dispositif de logement pour le support d'un noyau de fer lamellé (3) et/ou de la bobine de mesure (21), **en ce que** le dispositif de logement comprend de préférence un actionneur pour la rotation du noyau de fer lamellé (3), afin de permettre une mesure dans différentes positions angulaires entre la bobine de mesure (21) et le noyau de fer lamellé (3), et/ou un actionneur pour la rotation de la bobine de mesure (21), afin de permettre une mesure dans différentes positions angulaires entre la bobine de mesure (21) et le noyau de fer lamellé (3).

9. Dispositif de mesure selon l'une des revendications 5 à 8,
**caractérisé en ce que**
la bobine de mesure (21) est conçue comme une bobine à air, de préférence comme une bobine à air blindée (21).

10. Dispositif de mesure selon l'une des revendications 5 à 9,
**caractérisé en ce que**
le dispositif de logement comprend un dispositif de blindage afin de blinder le noyau de fer lamellé (3) et/ou la bobine de mesure (21).

11. Dispositif de mesure selon l'une des revendications 5 à 10,
**caractérisé en ce que**
le dispositif de mesure (1) comprend une sonde de température et est conçu de façon à ce qu'il corrige automatiquement les écarts de température provoqués par les variations de température.

12. Procédé de fabrication pour des ensembles de tôles magnétiques (3), dans lequel certaines lamelles de tôles magnétiques sont munies d'une isolation et sont empilées sous la forme d'ensembles de tôles magnétiques (3) puis les pertes d'un tel ensemble de tôles magnétiques sont mesurées avec un dispositif de mesure selon l'une des revendications 5 à 11,
dans lequel, de préférence, les pertes d'un ensemble de tôles magnétiques (3) sont mesurées avant que l'ensemble de tôles magnétiques (3) soit muni d'un enroulement.

13. Procédé de fabrication selon la revendication 12, **caractérisé en ce que**
pour les pertes d'un ensemble de tôles magnétiques (3), une valeur limite est définie et les ensembles de tôles magnétiques (3), dont les pertes dépassent la valeur limite, sont identifiées comme défectueuses et/ou éliminées.

**14.** Procédé de fabrication selon la revendication 12 ou 13,

**caractérisé en ce que**

pour l'assurance qualité concernant chaque ensemble de tôles magnétiques (3) mesuré, la valeur de perte mesurée est enregistrées et plusieurs valeurs de mesure sont analysées statistiquement.

Figur 1

Figur 2

Figur 3

Figur 4

Figur 5

V(n002)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3907516 A1
- WO 2014094029 A1

- AT 390522 B

**In der Beschreibung aufgeführte Nicht-Patentliteratur**

- **C. F. FOO ; D. M. ZHANG.** A Resonant Method to Construct Core Loss of Magnetic Materials Using Impedance Analyser. *Der Artikel geht auf einen Vortrag der Power Electronic Specialist Conference 1998 zurück. Er wurde im PESC 98 Record 29th Annual IEEE,* 1997-2002